# EUROPÄISCHE PATENTSCHRIFT

(11) **EP 1 577 960 B1**
(45) Veröffentlichungstag und Bekanntmachung des Hinweises auf die Patenterteilung: **27.12.2006**
(21) Anmeldenummer: 04106329.8
(22) Anmeldetag: 06.12.2004
(51) Int. Cl.: H01L 41/053, H01L 41/083, F02M 51/00, F02M 51/06

(54) **Aktormodul**
Actuator module
Module d'actionneur

(30) Priorität: 17.03.2004 DE 102004012926
(43) Veröffentlichungstag der Anmeldung: 21.09.2005
(73) Patentinhaber: ROBERT BOSCH GMBH, 70442 Stuttgart (DE)
(72) Erfinder: Schmieder, Dietmar, 71706, Markgroeningen (DE); Kegel, Timo, 71638, Ludwigsburg (DE)

(56) Entgegenhaltungen:
- WO-A-20/04042226
- WO-A-20/04047191
- DE-A- 10 321 694
- DE-A- 19 715 487
- DE-A- 19 940 347

## Beschreibung

### Stand der Technik

Die Erfindung geht aus von einem Aktormodul nach der Gattung des Hauptanspruchs, siehe beispielsweise die Druckschrift DE 197 15 487 A.
Es ist schon ein Aktormodul vorgeschlagen worden, mit einem Aktor in einer Aktorhülse, die in einem Aktorgehäuse vorgesehen ist, mit zumindest einem stirnseitig an dem Aktor angeordneten Zentrierdeckel mit zwei Durchgangsöffnungen und mit einem das Aktorgehäuse stirnseitig verschließenden Gehäusedeckel mit zwei Anschlußöffnungen, wobei zwei Außenelektroden des Aktors zur Kontaktierung mit einer äußeren Spannungsquelle jeweils über eine der Durchgangsöffnungen und eine der Anschlußöffnungen nach außen verlaufen. Nachteilig ist, daß der Aktor in dem Aktorgehäuse und in der Aktorhülse durch direktes Zusammenwirken der weichen Außenelektroden mit den Durchgangsöffnungen und den Anschlußöffnungen ausgerichtet bzw. zentriert wird. Wegen der weichen Außenelektroden wird oft nur eine unzureichende Zentrierung des Aktors im Aktorgehäuse in der Aktorhülse erreicht, die zu einer Außermittigkeit des Aktors im Aktorgehäuse führen kann. Durch diese Außermittigkeit entstehen Biegekräfte, die den Aktor beschädigen können.

### Vorteile der Erfindung

Das erfindungsgemäße Aktormodul mit den kennzeichnenden Merkmalen des Hauptanspruchs hat demgegenüber den Vorteil, daß auf einfache Art und Weise eine Verbesserung dahingehend erzielt wird, daß eine zuverlässige und sehr genaue Zentrierung des Aktors im Aktorgehäuse und in der Aktorhülse erreicht wird, indem an dem Zentrierdeckel zumindest zwei Zentrierhülsen angeordnet sind, die die Außenelektroden jeweils ringförmig umschließen und die den Aktor in der Aktorhülse durch ein Zusammenwirken mit den Anschlußöffnungen des Gehäusedeckels zentrieren. Die zusätzlichen Zentrierhülsen sind im Zusammenwirken mit den Anschlußöffnungen des Gehäusedeckels stabiler und mechanisch belastbarer als es die weichen Außenelektroden im direkten Zusammenwirken mit den Anschlußöffnungen sein können, so daß eine deutlich bessere Zentrierung des Aktors in der Aktorhülse erzielbar ist als beim Stand der Technik.

Durch die in den Unteransprüchen aufgeführten Maßnahmen sind vorteilhafte Weiterbildungen und Verbesserungen des im Hauptanspruch angegebenen Aktormoduls möglich.

Besonders vorteilhaft ist, wenn die Zentrierhülsen in die Anschlußöffnungen des Gehäusedeckels hineinragen und eine zumindest nahezu spielfreie Verbindung bilden, da der Aktor auf diese Weise besonders genau in der Aktorhülse ausgerichtet ist.

In einem vorteilhaften Ausführungsbeispiel hat die erste Zentrierhülse einen runden Querschnitt und die zweite Zentrierhülse einen ovalen oder ellipsenförmigen Querschnitt, wobei die Anschlußöffnungen jeweils einen runden Querschnitt haben. Auf diese Weise werden Form- und Lagetoleranzen zugelassen, die fertigungstechnisch sehr kostengünstig zu realisieren sind.

Gemäß einer anderen vorteilhaften Ausführung weisen die erste Zentrierhülse und die zweite Zentrierhülse einen runden Querschnitt auf, wobei eine erste Anschlußöffnung einen runden Querschnitt hat und eine zweite Anschlußöffnung als Langloch ausgebildet ist.

Weiterhin vorteilhaft ist, wenn die zweite Zentrierhülse mit einem ovalen Querschnitt einen größten Durchmesser aufweist, der etwa dem Durchmesser der ersten Zentrierhülse mit rundem Querschnitt entspricht, da auf diese Weise eine spielfreie Verbindung erreichbar ist.

Sehr vorteilhaft ist es, wenn die erste Zentrierhülse und die zweite Zentrierhülse aus Kunststoff hergestellt sind.

Auch vorteilhaft ist, daß der Aktor ein piezoelektrischer Aktor ist, da auf diese Weise sehr kleine Hübe, kurze Schaltzeiten und dadurch eine sehr genaue Dosierung des eingespritzten Kraftstoffs erzielbar ist.

Desweiteren vorteilhaft ist, wenn der Aktor am Umfang eine Ummantelung aus wärmeleitfähigem Elastomer aufweist, da auf diese Weise die im Aktor entstehende Wärme besonders gut an das Aktorgehäuse abgeführt wird.

Darüber hinaus vorteilhaft ist, wenn der Zentrierdeckel eine Zentrieröffnung aufweist, die der Aktor durchragt, da der Zentrierdeckel auf diese Weise sehr einfach mit dem Aktor mechanisch gekoppelt ist.

Zeichnung

Zwei Ausführungsbeispiele der Erfindung sind in der Zeichnung vereinfacht dargestellt und in der nachfolgenden Beschreibung näher erläutert.

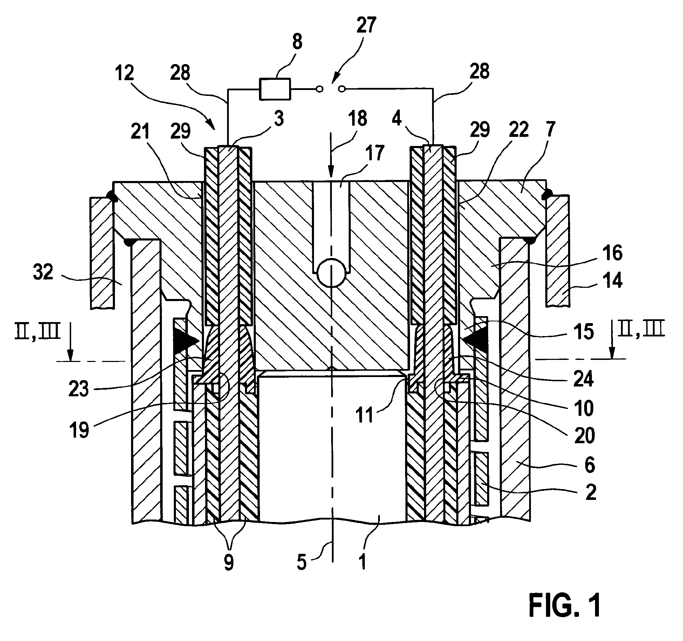

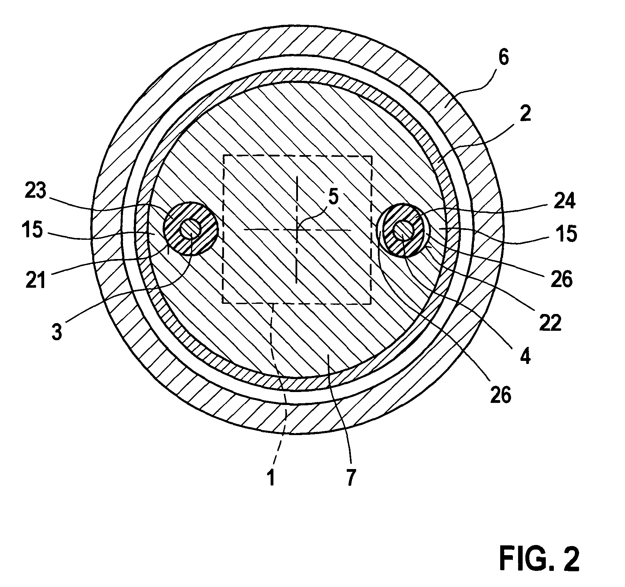

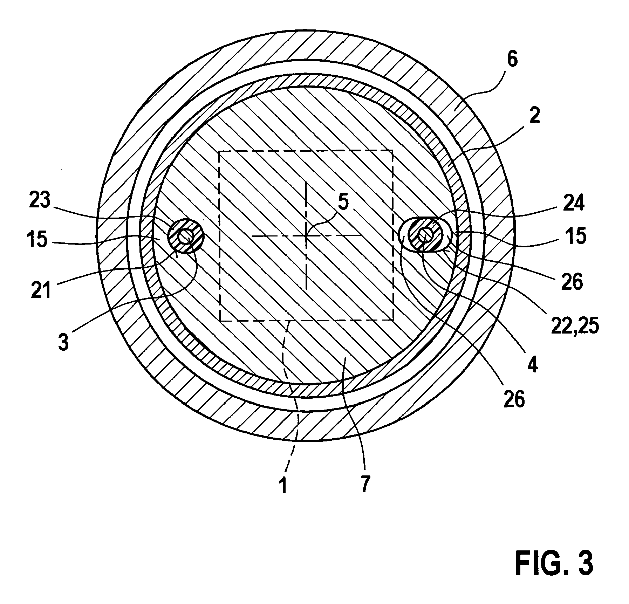

Fig.1 zeigt ein erfindungsgemäßes Aktormodul, Fig.2 im Schnitt eine Ansicht des erfindungsgemäßen Aktormoduls entlang der Linie II-II in Fig.1 und Fig.3 im Schnitt eine Ansicht des erfindungsgemäßen Aktormoduls entlang der Linie II-II in Fig.1 gemäß einem zweiten Ausführungsbeispiel.

### Beschreibung der Ausführungsbeispiele

Fig.1 zeigt ein erfindungsgemäßes Aktormodul.

Das erfindungsgemäße Aktormodul betrifft beispielsweise ein Brennstoffeinspritzventil, das Kraftstoff aus einem Kraftstoffspeicher in einen Brennraum oder ein Saugrohr einer Brennkraftmaschine einspritzt.

Ein Brennstoffeinspritzventil ist beispielsweise in der nicht vorveröffentlichten deutschen Patentanmeldung 103 10 790 vorgeschlagen worden, wobei deren Inhalt ausdrücklich Teil der Offenbarung dieser Anmeldung sein soll.

Das Aktormodul weist einen Aktor auf, beispielsweise einen Piezoaktor 1, der in einer beispielsweise zylinderförmigen Aktorhülse 2 vorgesehen ist. Die Aktorhülse 2 wiederum ist in einem Aktorgehäuse 6 angeordnet, das beispielsweise zylinderförmig ausgeführt ist. Das Aktorgehäuse 6 ist beispielsweise in einem Ventilgehäuse 14 vorgesehen.

Der Piezoaktor 1 ist aus einer Vielzahl von aufeinander geschichteten Keramikschichten zusammengesetzt, die übereinander geschichtet einen sogenannten Multilayer-Stapel bilden. Zwischen den piezoelektrischen Keramikschichten ist jeweils eine Elektrodenschicht vorgesehen, die beispielsweise auf die Keramikschichten mittels Siebdrucktechnik aufgedruckt sind. Die Keramikschichten sind elektrisch nichtleitend und polarisierbar. Der Piezoaktor 1 erstreckt sich in Richtung einer Aktorachse 5 und ist beispielsweise quaderförmig mit einem quadratischen oder rechteckigen Querschnitt ausgebildet.

Der Piezoaktor 1 hat zwei Außenelektroden, eine erste Außenelektrode 3 und eine zweite Außenelektrode 4, die mit den Elektrodenschichten des Piezoaktors 1 beispielsweise über sogenannte Bondingdrähte elektrisch verbunden sind. Die Außenelektroden 3,4 haben beispielsweise einen Durchmesser von 0,8 Millimeter und bestehen aus Messing.

Zwischen den Außenelektroden 3,4 kann eine elektrische Spannung von einer Spannungsquelle 27 anliegen, wobei die elektrische Spannung beispielsweise mittels eines elektronischen Steuergerätes 8 beispielsweise getaktet ein- oder abgeschaltet wird. Beim Anliegen einer Spannung zwischen den Außenelektroden wird in bekannter Weise eine Längung des Piezoaktors 1 um einen Hub bewirkt.

Die Aktorhülse 2 ist beispielsweise eine zylinderförmige elastische Rohrfeder, die den Piezoaktor 1 vor äußeren mechanischen Einwirkungen, beispielsweise Biegespannungen, Zugspannungen und Torsionsspannungen, schützt. Eine Rohrfeder ist beispielsweise in der nicht vorveröffentlichten deutschen Patentanmeldung 103 10 787 vorgeschlagen worden, wobei deren Inhalt ausdrücklich Teil der Offenbarung dieser Anmeldung sein soll.

Der Piezoaktor 1 weist am Umfang beispielsweise eine Ummantelung 9 auf, die den Aktor 1 unmittelbar umgibt und der Wärmeableitung in Richtung der Aktorhülse 2 dient. Die Ummantelung 9 besteht beispielsweise aus einem Elastomer mit einer guten Wärmeleitfähigkeit.

An dem Piezoaktor 1 ist stirnseitig ein beispielsweise zylinderförmiger Zentrierdeckel 10 vorgesehen mit einer Zentrieröffnung 11, die der Piezoaktor 1 in Richtung der Aktorachse 5 durchragt. Der Zentrierdeckel 10 ist beispielsweise auf den Piezoaktor 1 aufgesetzt und nur durch einen quer zur Aktorachse 5 wirkenden Formschluß mit diesem verbunden. Auf diese Weise ist der Zentrierdeckel 10 mit dem Piezoaktor 1 nur quer zur Aktorachse 5 mechanisch gekoppelt. Die Zentrieröffnung 11 ist beispielsweise wie der Piezoaktor 1 quadratisch ausgebildet. Der Zentrierdeckel 10 ist beispielsweise aus einem Kunststoff hergestellt.

Die Außenelektroden 3,4 verlaufen von den mit den Elektrodenschichten verbundenen Bondingdrähten ausgehend durch die Ummantelung 9 des Piezoaktors 1 in Richtung der Aktorachse 5 und durchdringen dabei den Zentrierdeckel 10, die Aktorhülse 2 und das Aktorgehäuse 6, um außerhalb des Aktorgehäuses 6 auf einer Anschlußseite 12 des Aktormoduls mit einer elektrischen Anschlußleitung 28 kontaktiert zu werden. Die Außenelektroden 3,4 sind beispielsweise vom Zentrierdeckel 10 ausgehend in Richtung Spannungsquelle 27 von einer Isolierschicht 29 umschlossen.

Das Ventilgehäuse 14, das Aktorgehäuse 6 und die Aktorhülse 2 sind stirnseitig, auf der Anschlußseite 12 des Aktormoduls, von einem Gehäusedeckel 7 verschlossen, der beispielsweise mit einem ersten Absatz 15 stirnseitig in die Aktorhülse 2, mit einem zweiten Absatz 16 stirnseitig in das Aktorgehäuse 6 und mit seinem Außenumfang in das Ventilgehäuse 14 hineinragt. Der Gehäusedeckel 7 zentriert auf diese Weise das Aktorgehäuse 6 und die Aktorhülse 2 in dem Ventilgehäuse 14. Es können aber auch separate Deckel vorgesehen sein, die jeweils das Ventilgehäuse 14, das Aktorgehäuse 6 und die Aktorhülse 2 verschließen. Der erste Absatz 15 des Gehäusedeckels 7 ist mit der Aktorhülse 2 und der zweite Absatz 16 mit dem Aktorgehäuse 6 kraftschlüssig und/oder stoffschlüssig verbunden, beispielsweise verschweißt.

Der Gehäusedeckel 7 weist auf der Anschlußseite 12 des Aktormoduls beispielsweise einen Eingangskanal 17 auf, der beispielsweise an eine Kraftstoffleitung 18 angeschlossen ist, um Kraftstoff über den Eingangskanal 17 in einen Spaltraum 32 zwischen dem Ventilgehäuse 14 und dem Aktorgehäuse 6 in Richtung einer einem Brennraum oder einem Saugrohr zugewandten Auslaßöffnung an einem Ventilsitz des Brennstoffeinspritzventils zu leiten.

Die erste Außenelektrode 3 durchdringt den Zentrierdeckel 10 durch eine erste Durchgangsöffnung 19 und den Gehäusedeckel 7 durch eine erste Anschlußöffnung 21. Die zweite Außenelektrode 4 durchragt den Zentrierdeckel 10 durch eine zweite Durchgangsöffnung 20 und den Gehäusedeckel 7 durch eine zweite Anschlußöffnung 22.

Um die Lage des Piezoaktors 1 in der Aktorhülse 2 fest zu definieren, sind an dem Zentrierdeckel 10 erfindungsgemäß eine erste Zentrierhülse 23 und eine zweite Zentrierhülse 24 vorgesehen, wobei die erste Zentrierhülse 23 die erste Außenelektrode 3 und die zweite Zentrierhülse 24 die zweite Außenelektrode 4 ringförmig umgibt. Die Zentrierhülsen 23,24 sind als hülsenförmige Erhöhung an dem Zentrierdeckel 10 vorgesehen, wobei diese beispielsweise einteilig an den Zentrierdeckel 10 mittels Spritzgußtechnik angespritzt sind und aus Kunststoff bestehen. Die Zentrierhülsen 23,24 sind beispielsweise konisch ausgebildet, um auf diese Weise die Einfädelung in die Anschlußöffnungen 21,22 zu erleichtern.

Durch die Zentrierung des Piezoaktors 1 in der Aktorhülse 2 mittels der Zentrierhülsen 23,24 am Zentrierdeckel 10 wird der Piezoaktor 1 beispielsweise auch bezüglich des Aktorgehäuses 6 zentriert.

Die Zentrierhülsen 23,24 des Zentrierdeckels 10 zentrieren den Piezoaktor 1 in der Aktorhülse 2 durch ein Zusammenwirken mit den Anschlußöffnungen 21,22 im Gehäusedeckel 7 und durch den quer zur Aktorachse 5 wirkenden Formschluß zwischen dem Zentrierdeckel 10 und dem Piezoaktor 1. Auf diese Weise wird eine zumindest nahezu spielfreie Verbindung zwischen dem Zentrierdeckel 10 und dem Gehäusedeckel 7 gebildet. Der Piezoaktor 1 ist außerdem zentrisch zu dem Aktorgehäuse 6 und dem Gehäusedeckel 7 angeordnet.

Der Zentrierdeckel 10 ragt mit den Zentrierhülsen 23,24 in die Anschlußöffnungen 21,22 des Gehäusedeckels 7 hinein und legt auf diese Weise die Position des Piezoaktors 1 in der Aktorhülse 2 fest, da der Piezoaktor 1 formschlüssig mit dem Zentrierdeckel 10 verbunden und der Gehäusedeckel 7 zur Aktorhülse 2 fest ausgerichtet ist.

Um Form- und Lagetoleranzen zwischen dem Gehäusedeckel 7 und dem Zentrierdeckel 10 mit den Zentrierhülsen 23,24 einerseits und zwischen dem Zentrierdeckel 10 und dem Piezoaktor 1 mit den Außenelektroden 3,4 andererseits zuzulassen, weist die erste Zentrierhülse 23 gemäß einem ersten Ausführungsbeispiel einen runden Querschnitt und die zweite Zentrierhülse 24 einen ovalen oder ellipsenförmigen Querschnitt auf, wobei die Anschlußöffnungen 21,22 jeweils einen runden Querschnitt haben. Auf diese Weise ist die Verbindung zwischen dem Piezoaktor 1 und dem Gehäusedeckel 7 nicht statisch überbestimmt, da die Verbindung zwischen der ovalen Zentrierhülse 24 und der kreisförmigen Anschlußöffnung 22 eine translatorische Ausgleichsbewegung, beispielsweise verursacht durch thermische Ausdehnung, zuläßt.

Fig.2 zeigt im Schnitt eine Ansicht des erfindungsgemäßen Aktormoduls entlang der Linie II-II in Fig.1.

Bei dem Aktormodul nach Fig.2 sind die gegenüber dem Aktormodul nach Fig.1 gleichbleibenden oder gleichwirkenden Teile durch die gleichen Bezugszeichen gekennzeichnet.

In Fig.2 ist der runde Querschnitt der ersten Zentrierhülse 23 und der ovale oder ellipsenförmige Querschnitt der zweiten Zentrierhülse 24 dargestellt, wobei die Anschlußöffnungen 21,22 jeweils einen runden Querschnitt haben. Auf diese Weise verbleibt zwischen der zweiten Zentrierhülse 24 mit dem ovalen oder ellipsenförmigen Querschnitt und der runden Anschlußöffnung 22 jeweils ein sichelförmiger Spalt 26 in radialer Richtung zur Aktorachse 5, so daß sich der Piezoaktor 1 mit der zweiten Außenelektrode 4 in Richtung der ersten Außenelektrode 3 oder in der ersten Außenelektrode 3 entgegengesetzter Richtung beispielsweise thermisch bedingt zusammenziehen oder ausdehnen kann. Die Durchmesser der Anschlußöffnungen 21,22, der Durchmesser der ersten Zentrierhülse 23 und das Maß des größten Durchmessers der zweiten Zentrierhülse 24 sind nahezu gleich groß.

Fig.3 zeigt im Schnitt eine Ansicht des erfindungsgemäßen Aktormoduls gemäß einem zweiten Ausführungsbeispiel entlang der Linie III-III in Fig.1.

Bei dem Aktormodul nach Fig.3 sind die gegenüber dem Aktormodulg nach Fig.1 und Fig.2 gleichbleibenden oder gleichwirkenden Teile durch die gleichen Bezugszeichen gekennzeichnet.

Das Aktormodul nach Fig.3 unterscheidet sich von dem Aktormodul nach Fig.2 darin, daß die erste Zentrierhülse 23 und die zweite Zentrierhülse 24 einen runden Querschnitt haben, wobei die erste Anschlußöffnung 21 einen runden Querschnitt aufweist und die zweite Anschlußöffnung 22 als Langloch 25 ausgebildet ist. Das Langloch 25 erstreckt sich sowohl in Richtung der ersten Außenelektrode 3 als auch in der ersten Außenelektrode 3 entgegengesetzter Richtung.

Der Durchmesser der ersten Anschlußöffnung 21 und das doppelte Maß der Radien der als Langloch ausgebildeten zweiten Anschlußöffnung 22 und der Durchmesser der Zentrierhülsen 23,24 sind nahezu gleich groß.

Diese Variante ist aufwendiger zu fertigen, bietet aber für den Piezoaktor 1 eine bessere Möglichkeit zur Ausgleichsbewegung.

## Patentansprüche

1. Aktormodul mit einem Aktor in einer Aktorhülse (2), die in einem Aktorgehäuse (6) vorgesehen ist, mit zumindest einem stirnseitig an dem Aktor (1) angeordneten Zentrierdeckel (10) mit zwei Durchgangsöffnungen und mit einem das Aktorgehäuse stirnseitig verschließenden Gehäusedeckel mit zwei Anschlußöffnungen, wobei zwei Außenelektroden (3, 4) des Aktors (1) jeweils über eine der Durchgangsöffnungen des Zentrierdeckels (10) und eine der Anschlußöffnungen (21, 22) des Gehäusedeckels (7) nach außen verlaufen, **dadurch gekennzeichnet, dass** an dem Zentrierdeckel (10) zumindest zwei Zentrierhülsen (23,24) angeordnet sind, die die Außenelektroden (3,4) jeweils ringförmig umschließen und die den Aktor (1) in der Aktorhülse (2) durch ein Zusammenwirken mit den Anschlußöffnungen (21,22) zentrieren.

2. Aktormodul nach Anspruch 1, **dadurch gekennzeichnet, dass** die Zentrierhülsen (23,24) in die Anschlußöffnungen (21,22) des Gehäusedeckels (7) hineinragen und eine zumindest nahezu spielfreie Verbindung bilden.

3. Aktormodul nach Anspruch 1, **dadurch gekennzeichnet, dass** die erste Zentrierhülse (23) einen runden Querschnitt und die zweite Zentrierhülse (24) einen ovalen oder ellipsenförmigen Querschnitt aufweist, wobei die Anschlußöffnungen (21,22) jeweils einen runden Querschnitt haben.

4. Aktormodul nach Anspruch 1, **dadurch gekennzeichnet, dass** die erste Zentrierhülse (23) und die zweite Zentrierhülse (24) einen runden Querschnitt aufweisen und eine erste Anschlußöffnung (21) einen runden Querschnitt hat und eine zweite Anschlußöffnung (22) als Langloch (25) ausgebildet ist.

5. Aktormodul nach Anspruch 3, **dadurch gekennzeichnet, dass** die zweite Zentrierhülse (24) einen größten Durchmesser aufweist, der etwa dem Durchmesser der ersten Zentrierhülse (23) entspricht.

6. Aktormodul nach Anspruch 1, **dadurch gekennzeichnet, dass** die erste Zentrierhülse (23) und die zweite Zentrierhülse (24) aus Kunststoff hergestellt sind.

7. Aktormodul nach Anspruch 1, **dadurch gekennzeichnet, dass** der Aktor (1) ein piezoelektrischer Aktor ist.

8. Aktormodul nach Anspruch 1, **dadurch gekennzeichnet, dass** der Aktor (1) am Umfang eine Ummantelung (9) aus einem Elastomer mit guter Wärmeleitfähigkeit aufweist.

9. Aktormodul nach Anspruch 1, **dadurch gekennzeichnet, dass** der Zentrierdeckel (10) eine Zentrieröffnung (11) aufweist, die der Aktor (1) durchragt.

10. Aktormodul nach Anspruch 1, **dadurch gekennzeichnet, dass** der Gehäusedeckel (7) das Aktorgehäuse (6) und die Aktorhülse (2) in einem Ventilgehäuse (14) zentriert.

## Claims

1. Actuator module having an actuator in an actuator sleeve (2) which is provided in an actuator housing (6), having at least one centring cover (10) which is arranged on the actuator (1) at an end side and has two passage openings, and having a housing cover which closes off the actuator housing at the end side and has two port openings, two outer electrodes (3, 4) of the actuator (1) extending outwards through in each case one of the passage openings of the centring cover (10) and one of the port openings (21, 22) of the housing cover (7), **characterized in that** at least two centring sleeves (23, 24) are arranged on the centring cover (10), said centring sleeves (23, 24) in each case annularly enclosing the outer electrodes (3, 4) and centring the actuator (1) in the actuator sleeve (2) by means of interaction with the port openings (21, 22).

2. Actuator module according to Claim 1, **characterized in that** the centring sleeves (23, 24) project into the port openings (21, 22) of the housing cover (7) and form an at least approximately play-free connection.

3. Actuator module according to Claim 1, **characterized in that** the first centring sleeve (23) has a round cross section and the second centring sleeve (24) has an oval or elliptical cross section, the port openings (21, 22) each having a round cross section.

4. Actuator module according to Claim 1, **characterized in that** the first centring sleeve (23) and the second centring sleeve (24) have a round cross section, a first port opening (21) has a round cross section and a second port opening (22) is formed as a slot (25).

5. Actuator module according to Claim 3, **characterized in that** the second centring sleeve (24) has a maximum diameter which approximately corresponds to the diameter of the first centring sleeve (23).

6. Actuator module according to Claim 1, **characterized in that** the first centring sleeve (23) and the second centring sleeve (24) are manufactured from plastic.

7. Actuator module according to Claim 1, **characterized in that** the actuator (1) is a piezoelectric actuator.

8. Actuator module according to Claim 1, **characterized in that**, at its periphery, the actuator (1) has a casing (9) composed of an elastomer having good thermal conductivity.

9. Actuator module according to Claim 1, **characterized in that** the centring cover (10) has a centring opening (11) through which the actuator (1) projects.

10. Actuator module according to Claim 1, **characterized in that** the housing cover (7) centres the actuator housing (6) and the actuator sleeve (2) in a valve housing (14).

## Revendications

1. Module actionneur comprenant un actionneur dans une douille d'actionneur (2) contenue dans un boîtier d'actionneur (6) comprenant au moins un couvercle de centrage (10) disposé sur le côté frontal de l'actionneur (1), muni de deux ouvertures de passage, et un couvercle de boîtier muni de deux ouvertures de raccordement fermant le boîtier d'actionneur sur le côté frontal, deux électrodes extérieures (3, 4) de l'actionneur (1) s'étendant vers l'extérieur respectivement à travers l'une des ouvertures de passage du couvercle de centrage (10) et l'une des ouvertures de raccordement (21, 22) du couvercle de boîtier (7),
**caractérisé en ce que**
sur le couvercle de centrage (10) au moins deux douilles de centrage (23, 24) sont disposées, lesquelles entourent chacune les électrodes extérieures (3, 4) de façon annulaire et centrent l'actionneur (1) dans la douille d'actionneur (2) grâce à une coopération avec les ouvertures de raccordement (21, 22).

2. Module actionneur selon la revendication 1,
**caractérisé en ce que**
les douilles de centrage (23, 24) font saillie dans les ouvertures de raccordement (21, 22) du couvercle de boîtier (7) et forment au moins une liaison sensiblement sans jeu.

3. Module actionneur selon la revendication 1,
**caractérisé en ce que**
la première douille de centrage (23) présente une section transversale ronde et la deuxième douille de centrage (24) une section transversale ovale ou elliptique, les ouvertures de raccordement (21, 22) ayant chacune une section transversale ronde.

4. Module actionneur selon la revendication 1,
**caractérisé en ce que**
la première douille de centrage (23) et la deuxième douille de centrage (24) présentent une section transversale ronde et une première ouverture de raccordement (21) a une section transversale ronde et une deuxième ouverture de raccordement (22) présente la forme d'un trou oblong (25).

5. Module actionneur selon la revendication 3,
**caractérisé en ce que**
la deuxième douille de centrage (24) présente un diamètre maximum qui correspond approximativement au diamètre de la première douille de centrage (23).

6. Module actionneur selon la revendication 1,
**caractérisé en ce que**
la première douille de centrage (23) et la deuxième douille de centrage (24) sont en matière plastique.

7. Module actionneur selon la revendication 1,
**caractérisé en ce que**
l'actionneur (1) est un actionneur piézo-électrique.

8. Module actionneur selon la revendication 1,
**caractérisé par**
une enveloppe (9) en élastomère d'une bonne conductibilité thermique sur la périphérie l'actionneur (1).

9. Module actionneur selon la revendication 1,
**caractérisé en ce que**
le couvercle de centrage (10) présente une ouverture de centrage (11) traversée par l'actionneur (1).

10. Module actionneur selon la revendication 1,
**caractérisé en ce que**
le couvercle de boîtier (7) centre le boîtier d'actionneur (6) et la douille d'actionneur (2) dans un boîtier de soupape (14).
